# EUROPEAN PATENT SPECIFICATION

(11) **EP 0 527 655 B1**
(45) Date of publication and mention of the grant of the patent: **02.11.2000**
(21) Application number: 92307424.9
(22) Date of filing: 13.08.1992
(51) Int. Cl.: H04N 1/46, H04N 1/40, G03F 5/00

(54) **Halftone Printing Screens**
Halbtondruckmasken
Ecrans d'impression en demi-teints

(30) Priority: 13.08.1991 NZ 239389; 18.11.1991 NZ 240636; 13.12.1991 NZ 240979; 01.05.1992 NZ 242583
(43) Date of publication of application: 17.02.1993
(60) Divisional application: 99124667.9
(73) Proprietor: MEGADOT SYSTEMS LIMITED, Wellington (NZ)
(72) Inventor: Ashworth, William Frederick, Johnsonville Wellington (NZ)
(74) Representative: Price, Paul Anthony King

(56) References cited:
- EP-A- 0 370 271
- DE-A- 2 025 609
- DE-A- 2 917 242

## Description

This invention relates to printing technology and in particular to halftone screens which include shapes which reduce the perceptibility of certain moiré effects and various tone jumps which are often seen.

In most printing processes it is only possible to apply a single tone of each available ink colour to the print media. Tone variation is then achieved by breaking up each image into fine dots of varying size on a halftone screen grid. Colour variation is normally achieved by superimposing screens of the primary colours cyan, magenta and yellow, plus black for definition. Ideally human vision integrates the dots over a well prepared image into an accurate impression of the original scene. A final image will almost always include a number of compromises between practical limitations and defects in the printing process, and what can actually be perceived by the human eye and brain.

Round dots at 45° to vertical are least perceptible for a given spacing or screen ruling (or conversely dot frequency), and single color images are conventionally printed in this manner. Other dot shapes or combinations of shapes such as square and "elliptical" (diamond shape) are sometimes used, but all have generally straight or outwardly curved edges around the full length of their perimeters. The dots are usually created in square cells forming rows spaced at between about 30/cm for newsprint and about 60/cm for higher quality images.

In light tones the dots remain distinct on a light background provided by the print medium, but merge in darker tones which then appear as light dots on a dark background. The printed and non-printed areas of an image therefore appear to reverse from dots to background and background to dots respectively as tone darkens.

When printing colour images undesirable moiré effects in the form of large and small scale patterns are often seen due to periodic alignment of the dots as a whole and of their edges. The large scale patterns are typically bands which intersect to form squares on the order of tens or more dots along each side. This effect is largely removed by suitable relative rotation of the colour screens such as by cyan 15°, magenta 45°, yellow 90° and black 75° anticlockwise from horizontal. Complex mathematical procedures are often used to establish suitable angles. Placing the screens without relative rotation or offset can cause colour shifts in an image where colours of differing opacity, particularly black and yellow, overlap consistently over a large region. Subtle colour shifts may occur in any case due to mis-registration of the screens during their superposition. The small scale patterns of moiré effects are typically rosettes on the order of a few dots width, which cause perceptible speckling of otherwise uniformly coloured areas. This effect has proved more difficult to remove.

A further problem often arises in printing halftone images, known as dot gain, amid tones where adjacent dots are so sufficiently large as to become linked by imprecision in their reproduction. For example in lithography, which includes offset printing, a greasy ink is confined to printing areas of an image plate by dampening the surrounding non-printing areas with water. Unfortunately surface tension at the ink/water interfaces can cause or enhance bridging between closely spaced printing areas creating sudden tone jumps. Ink absorption on poor quality print paper can also lead to bridging. Round and square dots formed in square cells naturally meet their nearest neighbours at 78% and 50% printing area densities respectively. Dot gain causes bridging at slightly lower densities and enhances bridging at slightly higher densities creating discontinuities in regions of an intended smoothly varying tone. This effect is also difficult to remove completely.

Preparation of halftone images is largely carried out using computer controlled devices such as scanners and image setters. A photograph or other artwork to be reproduced is scanned and the original scene is stored in electronic memory or output directly. The images can be manipulated and/or combined with text before a printing medium such as a film or plate is produced. It is normally only in the final output stages that an image is converted to halftone dot screens. The manipulations are complex software operations which may be varied to suit particular images. Similar software is used in other electronic printing and image setting processes such as desktop publishing. Precise control of the dot patterns is necessary in preparing acceptable images, and the computations required for high quality images are often extensive and time consuming. For example, software methods for reducing moiré effects are disclosed in US 4,084,183, (congruent screens), US 4,894,726 (quasi periodic screens), EP 370271 (elongated conventional dots), WO 90/10991 (rectilinear screen transposition) and WO 90/06034 (pseudo random variation of dot shapes). Some images are still prepared using conventional photomechanical equipment such as contact screens. Good summaries of known dot patterns, their various problems and moiré effects are to be found in Colour Screening Technology; A Tutorial on the Basic Issues, The Seybold Report on Desktop Publishing, Vol 6, No. 2, October 1991, Seybold Publications Inc., PA, USA, and Desktop to Press, Issue 9, February 1992, Peter Fink Communications Inc.,CA USA.

According to a first aspect of the present invention, there is provided a method of preparing halftone screens prior to printing a coloured image comprising the steps of:
(a) receiving information representing colour and tone variation in the image;
(b) processing the information to create halftone screens representing primary colours in the image, by
   1) creating cyan and magenta screens having printing areas with inwardly curved edges, and
   2) orienting each primary colour screen at an angle which is approximately a multiple of 45° to any other primary colour screen; and
(c) producing halftone screens representing primary colours in a form appropriate for subsequent printing of the coloured image.

Preferably, the method further comprises the step of creating the cyan and magenta screens having printing areas in light tones formed as dots which are increasingly elongated with darkening tones. The dots may join in two distinct stages as tone darkens.

Alternatively, the method further comprises the step of creating the cyan and magenta screens having non-printing areas in dark tones formed as dots which are increasingly elongated with lightening tones. The dots may join in two distinct stages as tone lightens.

In some embodiments, the method further comprises the step of creating cyan and magenta screens which are relatively offset.

In some embodiments, the method further comprises the step of creating cyan and magenta screens having printing areas which in light tones are inwardly curved on every edge.

In some embodiments, the method further comprises the step of creating every primary colour screen having printing areas with inwardly curved edges.

In some embodiments, the method further comprises the step of creating a black screen having printing areas with inwardly curved edges. Preferably, the yellow and black screens are oriented at approximately 90° to each other, or the black screen is oriented at an angle which is approximately a multiple of 45° to any other screen. The black screen may be created with a screen ruling which is reduced by a factor of approximately 0.71 relative to the cyan and magenta screens.

In some embodiments, the method further comprises the step of orienting the cyan and magenta screens at approximately 90° to each other.

According to a second aspect of the present invention, there is provided a method of printing halftone screens to form a coloured image, comprising the steps of:
(a) receiving information representing primary colour halftone screens, wherein cyan and magenta screens have printing areas with inwardly curved edges;
(b) orienting each primary colour screen at an angle which is approximately a multiple of 45° to any other primary colour screen; and
(c) superimposing and printing the oriented primary colour screens to form a coloured image.

Preferably, the method further comprises the steps of:
receiving information representing a black halftone screen,
orienting the black halftone screen at an angle which is approximately a multiple of 45° to any other screen, and
printing the oriented black colour screen with the primary colour screens to form the coloured image.

According to a third aspect of the present invention, there is provided a computer controlled apparatus for preparing halftone screens representing a coloured image, comprising:
means for scanning a previously recorded scene to produce information representing colour and tone variation in the scene;
means for processing the information to create halftone screens representing the primary colours and black tone variation in the scene; and
means for producing the halftone screens in or on an output medium;
   wherein the means for processing includes means for creating cyan and magenta screens having printing areas with inwardly curved edges, and means for orienting each primary colour screen at an angle which is approximately a multiple of 45° to any other primary colour screen.

Preferably, the means for processing further comprises means for producing tone variation in the primary colour halftone screens by creating printing areas which vary in elongation between light and dark tones.

Alternatively, the means for processing further comprises means for producing tone variation in the primary colour halftone screens by creating non-printing areas which vary in elongation between dark and light tones.

According to a fourth aspect of the present invention, there is provided a computer controlled apparatus for preparing halftone screens representing a coloured image, comprising:
(a) means for receiving information representing colour and tone variation in the image;
(b) means for processing the information to create halftone screens representing primary colours in the image; and
(c) means for producing halftone screens representing primary colours in a form appropriate for subsequent printing of the image;
   wherein the means for processing includes means for creating cyan and magenta screens having printing areas with inwardly curved edges, and means for orienting each primary colour screen at an angle which is approximately a multiple of 45° to any other primary colour screen.

Preferably, the means for processing includes means for producing tone variation in the primary colour halftone screens by creating printing areas which vary in elongation between light and dark tones. Preferably, the means for processing includes means for joining the printing areas in two distinct stages as tone darkens or lightens respectively.

Alternatively, the means for processing includes means for producing tone variation in the primary colour halftone screens by creating non-printing areas which vary in elongation between dark and light tones. Preferably, the means for processing includes means for joining the non-printing areas in two distinct stages as tone darkens or lightens respectively.

According to a fifth aspect of the present invention, there is provided a process of preparing a halftone image wherein tone variation in cyan and magenta screens is produced by the steps of:
creating printing areas which are inwardly curved edges; and
placing each primary colour screen at an angle which is a multiple of approximately 45° to any other primary colour screen.

According to a sixth aspect of the present invention, there is provided a halftone image wherein tone variations are produced at least in part by printed areas which have inwardly curved edges and in which each primary colour screen is oriented at an angle which is approximately a multiple of 45° to any other primary colour screen.

Preferably, tone variation in cyan and magenta screens is produced by printing areas in light tones formed as dots which are increasingly elongated in darker tones.

Preferably, cyan and magenta screens are oriented at approximately 90° to each other.

Preferably, yellow and black screens are oriented at approximately 90° to each other.

When the halftone image has a dot pattern created by printing dots having inwardly curved edges, in light tones the dots may resemble pin cushions having pronounced cusps. In dark tones the dots are effectively merged to create non-printing dots which may be oval shaped. As tone varies from light to dark, the pin cushions are increasingly elongated along one direction and meet their nearest neighbours in two distinct stages, first in the direction of elongation and then in a direction substantially perpendicular to it. The dot screen is typically formed from a square cell so there are typically four nearest neighbours symmetrically placed at equal distances. As tone continues to darken after the dots have joined, the elongation is gradually decreased so that the oval shaped non-printing dots approach round dots. The pattern may also be considered overall as a reversed elliptical dot pattern in which the ellipses vary from round to a maximum ellipticity and back to round across the full range of tones. When a number of screens are superimposed the inwardly curved edges of the printing areas do not align so readily to form perceptible rosettes as do conventional dots. Further, the elongation may be varied so that dot gain occurs in tones where its perceptibility also is minimised.

At the present time as this specification is prepared, the optimum uses and ramifications of the invention have not been fully explored. In preparing coloured images it has been found that the primary colour and black screens are best placed at 45° separations from each other. For example cyan 45°, magenta 135°, yellow 90° and black 0°. Screens which are separated by 90° may generally be regarded alternatively as being at 0° so that in this example there are essentially only two angles for computation of dot patterns, 0° and 45°. This represents a considerable computational simplification over conventional screen angles.

The cyan and magenta screens will normally have a deliberate offset or mis-registration from each other to avoid possible color shifts. Yellow and black screens may also be offset from each other, and may be printed with little or no elongation of the dots. The yellow and/or black screen rulings may also be increased and/or decreased relative to cyan and magenta. Final determination of these possibilities awaits full software implementation of the invention and will depend on particular images.

Examples of the invention will be described with reference to the drawings of which:
Figures 1a, 1b and 1c show coarse conventional round, square and elliptical dot patterns respectively, varying uniformly between light and dark tones;
Figure 2 is an illuminated globe image using a conventional variable round dot pattern;
Figure 3 shows reversal of a coarse conventional round dot pattern to produce printing areas having inwardly curved edges;
Figures 4a and 4b show reversal of a variable oval dot pattern in which the dots vary from round to oval and back to round;
Figures 5a, 5b and 5c show example variable oval dot outlines superimposed upon common centres
Figures 6a and 6b show respectively two conventional round dot screens overlapping at 30° and two reversed dot screens overlapping at 90°;
Figures 7a to 7i show example dot patterns for various screen combinations according to the invention;
Figures 8a to 8i show corresponding conventional round dot patterns for contrast with figures 7a to 7i;
Figure 9 is a flowchart indicating a general process in which the invention may be implemented; and
Figure 10 is a schematic diagram of existing hardware on which the invention may be implemented.

Referring to these figures it will be seen that the dot patterns are magnified about 10 to 100 times in black and white for purposes of their description. The visual effects resuiting from integration by the human eye over a halftone image at normal scales are not evident but should be appreciated by a skilled reader. Particularly the improvements to be obtained in colour images by inwards curvature of printing dot edges in light to middle tones and to be obtained in single color images by dot elongation will be appreciated.

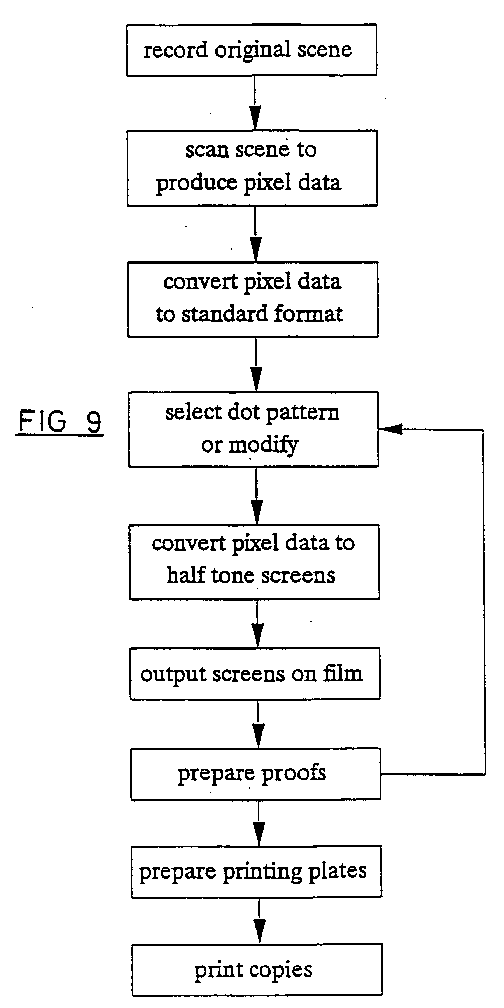

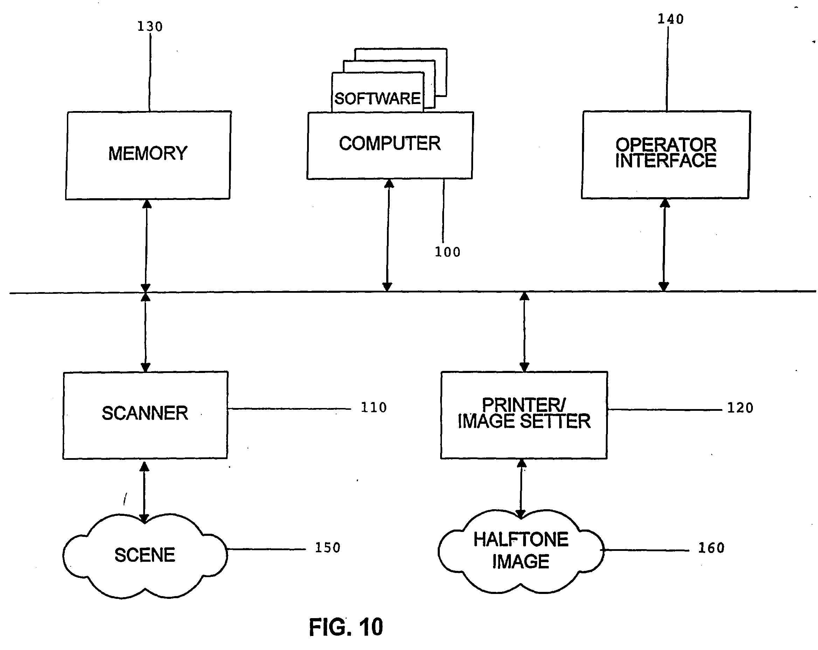

The various forms of computer hardware and software used to implement dot patterns according to the invention will also be known to the skilled reader, or at least will be available for consideration through the references given above, particularly the Seybold and Fink articles. For example, a range of desktop publishing and high end scanner equipment and software is available through suppliers such as Adobe, Agfa, Crosfield, Linotype-Hell and Scitex. As new patterns are developed the hardware and/or software may be correspondingly upgraded. A typical process of preparing a halftone image, particularly a colored image as implemented on their equipment, is outlined in the flowchart of figure 9. Typical hardware is indicated in Figure 10.

In general terms, a scene is electronically scanned from a film or other artwork to be printed, or recorded in some other digital process, and the data obtained is stored as pixel based color and intensity information. The pixels are generally aligned with the vertical and horizontal directions of movement of the scanner. The data is then processed into a standardised format such as known under the trade mark POSTSCRIPT and from there into up to four halftone screens which represent the primary colors and black as required. These screens are created from the pixel information by various raster image processor programs which calculate the dot shapes, dot frequencies and screen rotation angles. An operator normally has a range of dot patterns available through software installed on the equipment. The operator selects appropriate shapes, frequencies and angles in reaching an acceptable image during proofing. In traditional printing operations each screen is then output individually, to create up to four films or plates which are used to print multiple copies of the final black and white or colored image. This part of the process is known as image setting in the case of desktop publishing and as scanner output in the case of "high end" systems. In other computer based operations such as ink jet or laser printing it is possible to output a colored image directly.

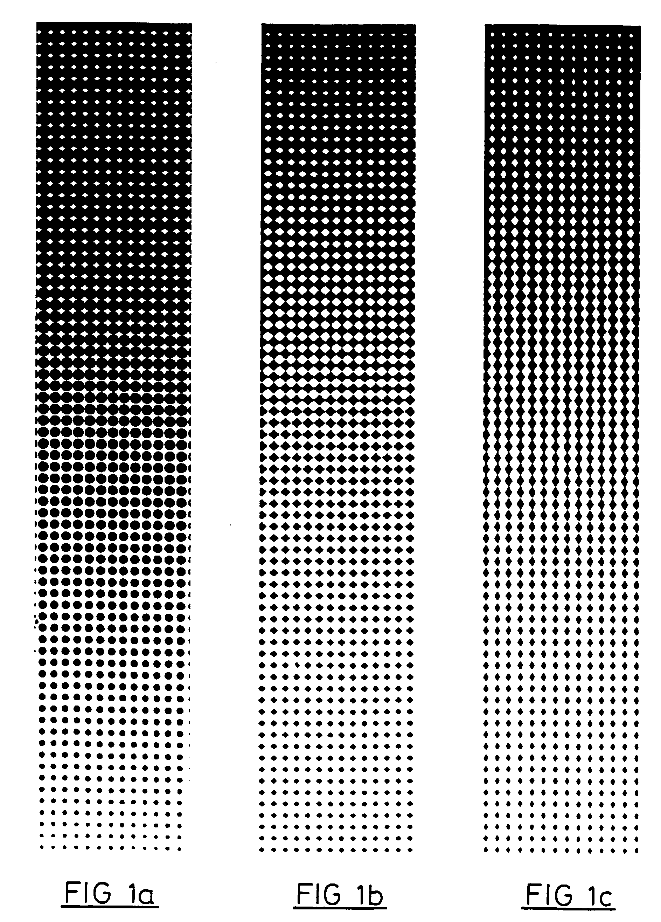

Figures 1a, 1b and 1c show conventional round, square and "elliptical" dot patterns respectively, varying smoothly in size from about 10% print area density in light tones to about 90% area density in dark tones. Round dots have outwardly curved edges by definition whereas square or diamond shaped dots have flat edges between four points. The square patterns are invertible in that the printed areas in light tones have similar shapes to the non-printed areas in dark tones and vice versa.

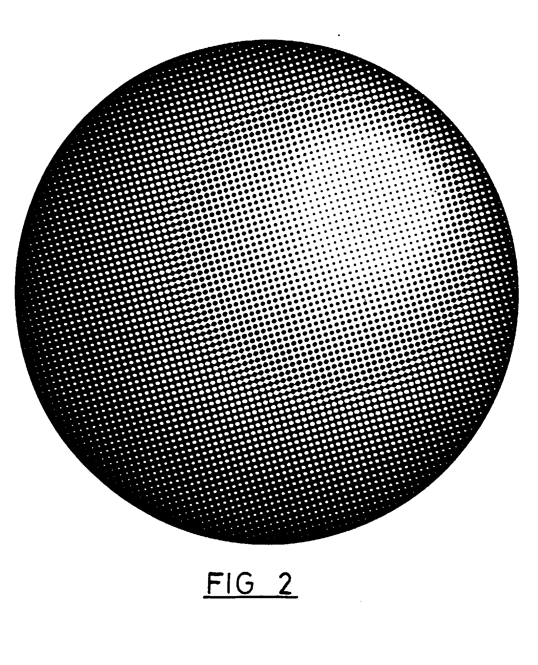

Figure 2 demonstrates a more complicated dot pattern in which conventional round dots in light tones become square dots in middle tones with reversal of the round dots in dark tones. This is often referred to as the Euclidean dot pattern. The edge curvature of printed areas correspondingly changes from outward to flat to inward respectively. Moiré effects do not arise in Figures 1 and 2 as only a single screen is present in each case. Dot gain is not apparent due to the magnification.

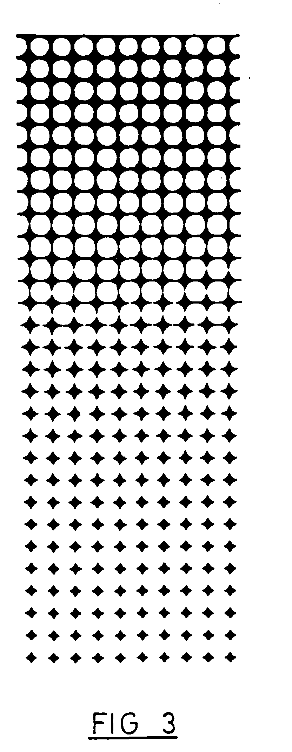

Figure 3 shows a reversed round dot pattern varying uniformly from light to dark tones. The dots in light tones have inwardly curved edges between cusps distributed on two planes of mirror symmetry. Their points could perhaps be flattened or rounded as desired. Each dot meets its four nearest neighbours simultaneously at around 22% area density. Otherwise the inwards curvature extends along substantially the full length of all printed areas. The non-printed areas have corresponding outwardly curved edges and separate to appear as round dots in the dark tones. Overall the pattern is seen to be effectively a reversal or negative of the conventional round dot pattern in Figure 1a throughout the entire range of tones, and in this respect may be considered a pattern of light round dots on a dark printed background. By virtue of this reversal all print area edges are circles or circular arcs but could be other smooth curves as desired, or as required to link with the end points. Also the dots need not be fourfold symmetrical as shown. Rosette moiré effects in coloured images can be reduced by printing dot patterns having inwardly curved edges as will be evident from later figures in which two screens are superimposed. Tone jumps due to dot gain remain a problem however, as with the conventional round dot pattern.

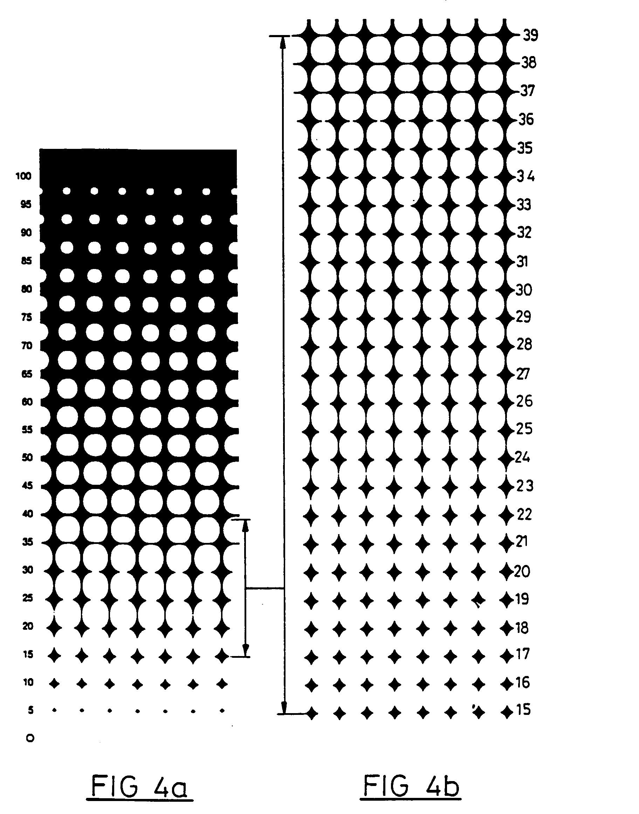

Figures 4a and 4b show a reversed variable oval dot pattern suitable for use in the invention. In this form the generally pin cushion shaped dots are elongated along a plane of mirror symmetry in light quarter to middle tones, so that nearest neighbours meet first vertically along the direction of tone darkening and then second horizontally in the corresponding perpendicular direction. Each dot meets two opposing pairs in two distinct stages of around 22% and 36% area density. This pattern is seen to be effectively a reversal or negative of a round dot pattern in which the dots become oval in middle tones. Figure 4a shows a full range of tone from 0% to 100% while Figure 4b shows more detail of the fourfold/twofold or alternatively the round/oval variation from about 15% to 39% area density. Rosette moiré effects can be reduced as with the pattern of Figure 3, but now by controlling dot elongation the perceptibility of any tone jumps can also be reduced by splitting dot gain into two less obvious stages which in turn may be shifted among a range of tones.

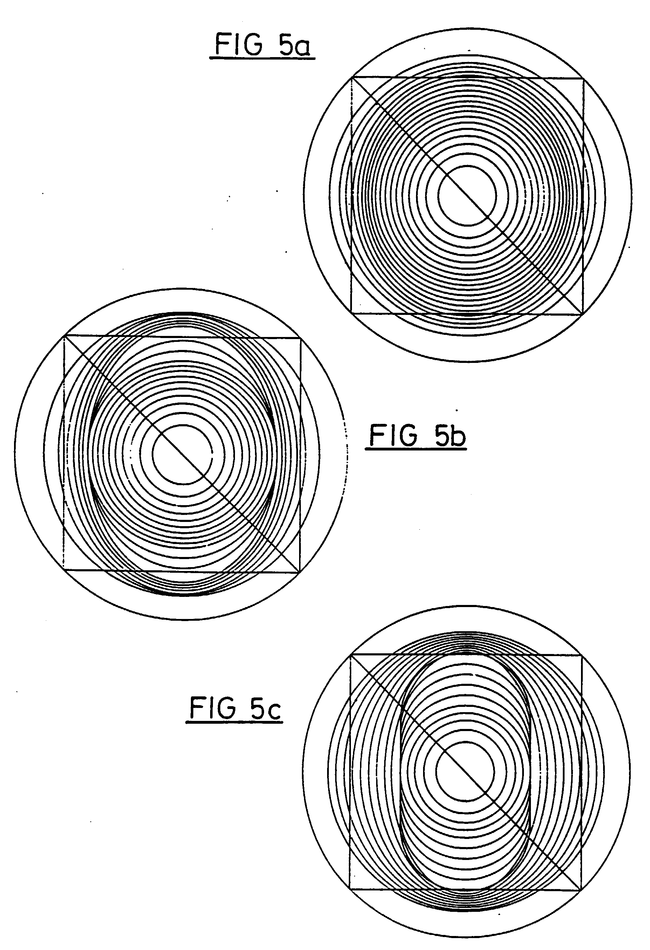

Figures 5a, 5b and 5c show example variations of dot edges suitable for use in the invention superimposed on common centres. The diagonally lined squares facilitate comparison and measurement in production. The edges are not necessarily mathematical ellipses but may take any suitable oval or approximately similar form as can be generated by computer. Figure 5a shows the gentle round-oval-round variation of Figures 4a and 4b. Figures 5b and 5c show more severe distortions resulting in greater separation of the dot gain stages. These figures are contour patterns which have been used in manual preparation of threshold matrices as described on pages 15 and 16 of the Seybold Report mentioned above.

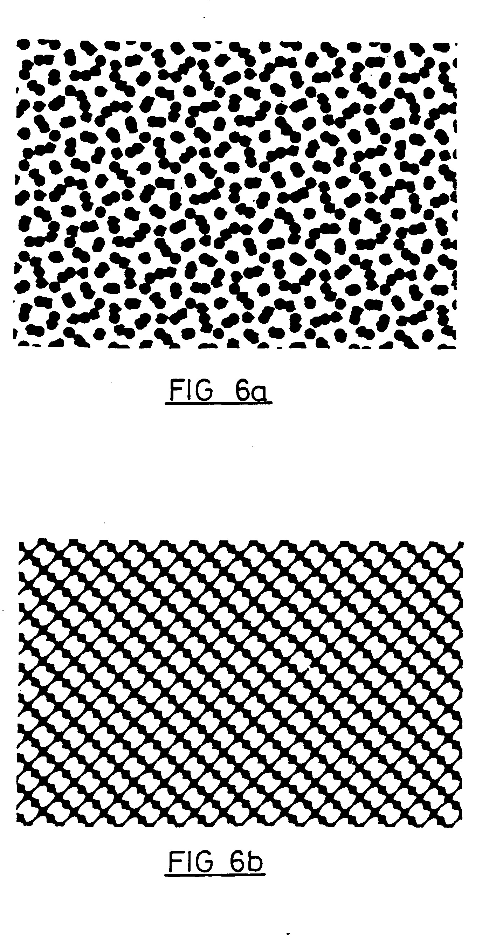

Figures 6a and 6b are an illustration of the reduction in rosette moiré effect which can be achieved. Figure 6a shows rosettes created by superimposing two conventional round dot screens at 30°, as is common with cyan and magenta in coloured images. Figure 6b shows a smoother variation of similar tones created by superimposing two reversed variable oval dot screens at 90° according to the invention. Preparing colored images using all four possible screens is less straightforward.

The primary color screens are placed at 45° angular separations, such as cyan 45°, magenta 135° and yellow 90°, with black placed at 0° or 90°. The cyan and magenta screens use elongated dots of the reversed variable oval dot pattern, while yellow may use only the reversed round dot pattern. Black may only need the reversed round dot pattern, or may even give satisfactory images using the conventional round dot pattern itself.

It has also been found that black dots are often not necessary in preparing a well defined colored image. For example, the primary color screens may be used alone at the angles and with the patterns mentioned above.

It is also generally required that the cyan and magenta screens should be offset from each other to avoid possible color shifts. The offset should be about half a cell parallel with either of the screen directions, for best results in view of the accidental offsets which often occur during printing. Yellow and black screens should also sometimes be offset to avoid color shifts. The nature of these offsets has yet to be fully explored but will be evident to a skilled reader working on a particular image.

In some images the possibility of color shifts and moiré effects has been reduced with the 45° angles and reversed patterns mentioned above, by decreasing the black screen ruling (increasing the dot frequency) by a factor of about cosine 45° (about 0.71) relative to cyan and magenta. In a smaller number of cases the yellow screen ruling has been correspondingly increased by this factor. Again the nature of these adjustments to the spacings has yet to be fully explored, but will be evident to a skilled reader working on particular images.

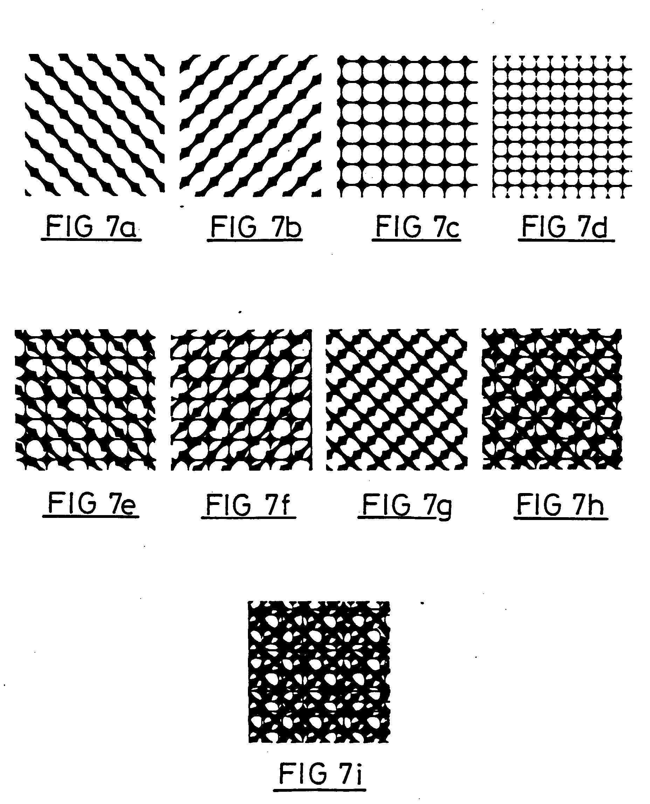

Figures 7a to 7i show the dot patterns of a test which has been carried out to date according to the invention. Figures 7a to 7d represent individual screens of cyan 135°, magenta 45°, yellow 0° and black 0/90°, all at tone values where the printing and non-printing areas have linked with two or four of their nearest neighbours. Cyan and magenta use the reversed variable oval dot pattern. Yellow and black use simply the reversed round dot pattern. The black screen ruling has been reduced by a factor of about 0.71 relative to the others. Figures 7e to 7g show screens superimposed in pairs, namely cyan/yellow, magenta/yellow and cyan/magenta. In figure 7f and 7g the cyan and magenta have been offset by half a cell parallel to their screen directions, which are diagonal on the page as shown. The visible effect is somewhat unrealistic in that yellow normally has substantially less impact on the eye than the darker colors but here all colors must be shown equally in black. Figure 7h shows the cyan, magenta and yellow screens superimposed. A very slight moiré effect is apparent primarily because the colors must be shown in black as mentioned. Figure 7i shows the black screen of figure 7d superimposed on figure 7h. Again there is a slight moiré effect due to the overall black color representation whereas under normal printing circumstances the colors would have different impacts and the final image screen would be virtually moiré free.

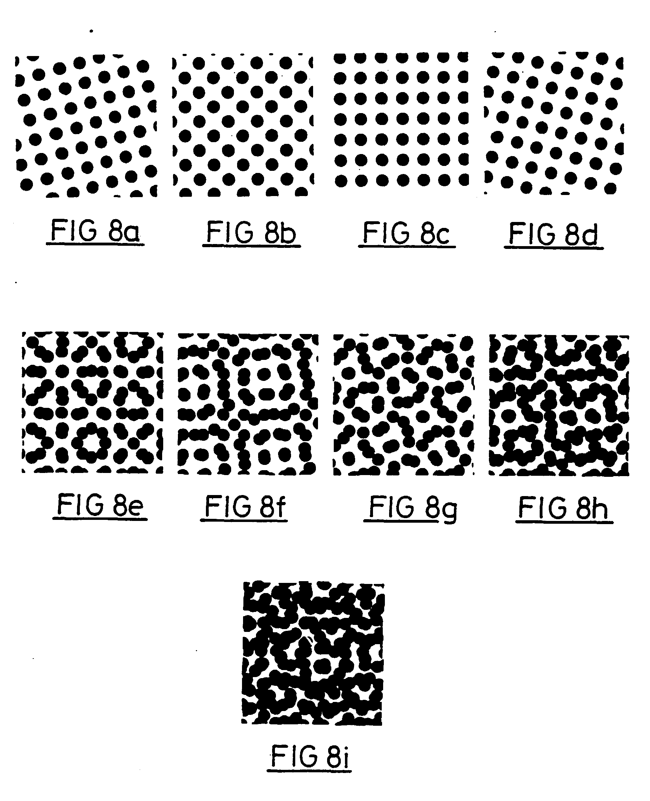

Figures 8a to 8i show an attempt to contrast with figures 7a to 7i, the conventional round dot patterns which would typically have been used. Figures 8a to 8d represent individual screens of cyan 15°, magenta 45°, yellow 0° and black 75°. Figures 8e to 8g show these screens superimposed in pairs, namely cyan/yellow, magenta/yellow and cyan/magenta. Figure 8h shows the cyan, magenta and yellow screens superimposed. Figure 8i shows the black screen of figure 8d superimposed on figure 8h. Both large and small scale moiré effects can be seen in these figures, although the effects are not so apparent as they normally would be in a complete colored image at normal screen rulings. The effects of dot gain are not at all apparent due to the artificial manner in which these figures must be presented.

As noted above, it is known from the prior art that preparation of halftone images is carried out using computer controlled devices such as scanners and imagesetters. A photograph or other artwork to be reproduced is scanned or otherwise generated, and the original scene is stored in electronic memory or output directly. Figure 10 shows an exemplary block diagram of a high end computer controlled apparatus which is known from the prior art and can be used by a human operator in implementing the process of Figure 9. The operator interfaces with the apparatus through a keyboard or other appropriate hardware and software 140. A recorded scene 150 such as a photograph is passed under scanner 110 to produce pixel data. That data is then stored in a memory 130 which is typically a hard disc. A computer processor 100 is then used to select and modify dot patterns based on color and shading information in the pixel data. Halftone screens in primary colors and/or black are output through a printer or imagesetter 120, or may be output to a further memory device. The scenes are combined in preparation of a high quality halftone image 160.

## Claims

1. A method of preparing halftone screens prior to printing a coloured image comprising the steps of:
(a) receiving information representing colour and tone variation in the image;
(b) processing the information to create halftone screens representing primary colours in the image, by
1) creating cyan and magenta screens having printing areas with inwardly curved edges, and
2) orienting each primary colour screen at an angle which is approximately a multiple of 45° to any other primary colour screen; and
(c) producing halftone screens representing primary colours in a form appropriate for subsequent printing of the coloured image.

2. A method according to claim 1, further comprising the step of:
creating the cyan and magenta screens having printing areas in light tones formed as dots which are increasingly elongated with darkening tones.

3. A method according to claim 2, further comprising:
joining the dots in two distinct stages as tone darkens.

4. A method according to claim 1, further comprising the step of
creating the cyan and magenta screens having non-printing areas in dark tones formed as dots which are increasingly elongated with lightening tones.

5. A method according to claim 4, further comprising:
joining the dots in two distinct stages as tone lightens.

6. A method according to claim 1, further comprising the step of:
creating cyan and magenta screens which are relatively offset.

7. A method according to claim 1, further comprising the step of:
creating cyan and magenta screens having printing areas which in light tones are inwardly curved on every edge.

8. A method according to claim 1, further comprising the step of:
creating every primary colour screen having printing areas with inwardly curved edges.

9. A method according to claim 1, further comprising the step of:
creating a black screen having printing areas with inwardly curved edges.

10. A method according to claim 9, further comprising the step of:
orienting yellow and black screens at approximately 90° to each other.

11. A method according to claim 9, further comprising the step of:
orienting the black screen at an angle which is approximately a multiple of 45° to any other screen.

12. A method according to claim 11, further comprising the step of:
creating the black screen with a screen ruling which is reduced by a factor of approximately 0.71 relative to the cyan and magenta screens.

13. A method according to claim 1, further comprising the step of:
orienting the cyan and magenta screens at approximately 90° to each other.

14. A method of printing halftone screens to form a coloured image, comprising the steps of:
(a) receiving information representing primary colour halftone screens, wherein cyan and magenta screens have printing areas with inwardly curved edges;
(b) orienting each primary colour screen at an angle which is approximately a multiple of 45° to any other primary colour screen; and
(c) superimposing and printing the oriented primary colour screens to form a coloured image.

15. A method according to claim 14, further comprising the steps of:
receiving information representing a black halftone screen,
orienting the black halftone screen at an angle which is approximately a multiple of 45° to any other screen, and
printing the oriented black colour screen with the primary colour screens to form the coloured image.

16. A computer controlled apparatus for preparing halftone screens representing a coloured image, comprising:
means for scanning a previously recorded scene to produce information representing colour and tone variation in the scene;
means for processing the information to create halftone screens representing the primary colours and black tone variation in the scene; and
means for producing the halftone screens in or on an output medium;
wherein the means for processing includes means for creating cyan and magenta screens having printing areas with inwardly curved edges, and means for orienting each primary colour screen at an angle which is approximately a multiple of 45° to any other primary colour screen.

17. Apparatus according to claim 16, wherein the means for processing further comprises means for producing tone variation in the primary colour halftone screens by creating printing areas which vary in elongation between light and dark tones.

18. Apparatus according to claim 16, wherein the means for processing further comprises means for producing tone variation in the primary colour halftone screens by creating non-printing areas which vary in elongation between dark and light tones.

19. A computer controlled apparatus for preparing halftone screens representing a coloured image, comprising:
(a) means for receiving information representing colour and tone variation in the image:
(b) means for processing the information to create halftone screens representing primary colours in the image; and
(c) means for producing halftone screens representing primary colours in a form appropriate for subsequent printing of the image;
wherein the means for processing includes means for creating cyan and magenta screens having printing areas with inwardly curved edges, and means for orienting each primary colour screen at an angle which is approximately a multiple of 45° to any other primary colour screen.

20. Apparatus according to claim 19, wherein the means for processing includes means for producing tone variation in the primary colour halftone screens by creating printing areas which vary in elongation between light and dark tones.

21. Apparatus according to claim 20, wherein the means for processing includes means for joining the printing areas in two distinct stages as tone darkness or lightens respectively.

22. Apparatus according to claim 19, wherein the means for processing includes means for producing tone variation in the primary colour halftone screens by creating non-printing areas which vary in elongation between dark and light tones.

23. Apparatus according to claim 22, wherein the means for processing includes means for joining the non-printing areas in two distinct stages as tone darkness or lightens respectively.

24. A process of preparing a halftone image wherein tone variation in cyan and magenta screens is produced by the steps of:
creating printing areas which have inwardly curved edges; and
placing each primary colour screen at an angle which is a multiple of approximately 45° to any other primary colour screen.

25. A halftone image wherein tone variations are produced at least in part by printed areas which have inwardly curved edges and in which each primary colour screen is oriented at an angle which is approximately a multiple of 45° to any other primary colour screen.

26. An image according to claim 25 wherein tone variation in cyan and magenta screens is produced by printing areas in light tones formed as dots which are increasingly elongated in darker tones.

27. An image according to claim 25 wherein cyan and magenta screens are oriented at approximately 90° to each other.

28. An image according to claim 25 wherein yellow and black screens are oriented at approximately 90° to each other.

## Patentansprüche

1. Verfahren zur Herstellung von Halbtonrastern vor dem Drucken einer farbigen Abbildung mit den Stufen, in denen man
(a) Information empfängt, welche Farbe und Tonabweichung in der Abbildung entspricht,
(b) die Information unter Erzeugung von Halbtonrastern, welche primären Farben in der Abbildung entsprechen, verarbeitet, indem man
1) Cyan- und Magente-Raster erzeugt, welche Druckbereiche mit einwärts gekrümmten Rändern aufweisen, und
2) jedes primäre Farbraster in einem Winkel ausrichtet, welcher etwa ein Vielfaches von 45° zu jedem anderen primären Farbraster ist, und
(c) Halbtonraster erzeugt, welche primären Farben in einer für anschließendes Drucken der farbigen Abbildung geeigneten Form entsprechen.

2. Verfahren nach Anspruch 1, das weiterhin die Stufe umfaßt, in der man
die Cyan- und Magenta-Raster mit Druckbereichen in hellen Tönen, die als Punkte ausgebildet sind, welche zunehmend mit dunkler werdenden Tönen verlängert sind, erzeugt.

3. Verfahren nach Anspruch 2, welches weiterhin umfaßt, daß man die Punkte in zwei verschiedenen Stufen miteinander verbindet, während der Ton dunkler wird.

4. Verfahren nach Anspruch 1, welches weiterhin die Stufe umfaßt, in der man
die Cyan- und Magenta-Raster mit Nicht-Druckbereichen in dunklen Tönen, die als Punkte ausgebildet sind, welche zunehmend mit heller werdenden Tönen verlängert sind, erzeugt.

5. Verfahren nach Anspruch 4, welches weiterhin umfaßt, daß man die Punkte in zwei verschiedenen Stufen miteinander verbindet, während der Ton heller wird.

6. Verfahren nach Anspruch 1, welches weiterhin die Stufe umfaßt, in der man
Cyan- und Magenta-Raster erzeugt, die relativ zueinander versetzt sind.

7. Verfahren nach Anspruch 1, welches weiterhin die Stufe umfaßt, in der man
Cyan- und Magenta-Raster mit Druckbereichen erzeugt, welche an jedem Rand in hellen Tönen einwärts gekrümmt sind.

8. Verfahren nach Anspruch 1, welches weiterhin die Stufe umfaßt, in der man
jedes primäre Farbraster mit Druckbereichen mit einwärts gekrümmten Rändern erzeugt.

9. Verfahren nach Anspruch 1, welches weiterhin die Stufe umfaßt, in der man
ein schwarzes Raster mit Druckbereichen mit einwärts gekrümmten Rändern erzeugt.

10. Verfahren nach Anspruch 9, welches weiterhin die Stufe umfaßt, in der man
gelbe und schwarze Raster etwa 90° zueinander ausrichtet.

11. Verfahren nach Anspruch 9, welches weiterhin die Stufe umfaßt, in der man
das schwarze Raster in einem Winkel ausrichtet, welcher etwa ein Vielfaches von 45° gegenüber jedem anderen Raster ist.

12. Verfahren nach Anspruch 11, welches weiterhin die Stufe umfaßt, in der man
das schwarze Raster mit einer Rasterteilung erzeugt, welche gegenüber den Cyan- und Magenta-Rastern um einen Faktor von etwa 0,71 reduziert ist.

13. Verfahren nach Anspruch 1, welches weiterhin die Stufe umfaßt, in der man
die Cyan- und Magenta-Raster etwa 90° zueinander ausrichtet.

14. Verfahren zum Drucken von Halbtonrastern zur Erzeugung einer farbigen Abbildung mit den Stufen, in denen man
(a) Information empfängt, welche Primärfarbenhalbtonrastern entspricht, worin Cyan- und Magenta-Raster Druckbereiche mit einwärts gekrümmten Rändern aufweisen,
(b) jedes Primärfarbenraster in einem Winkel ausrichtet, welcher gegenüber jedem anderen Primärfarbenraster etwa ein Vielfaches von 45° ist, und
(c) die ausgerichteten Primärfarbenraster zur Erzeugung einer farbigen Abbildung übereinander legt und druckt.

15. Verfahren nach Anspruch 14, welches weiterhin die Stufen umfaßt, in denen man
Information empfängt, welche einem schwarzen Halbtonraster entspricht,
das schwarze Halbtonraster in einem Winkel ausrichtet, welcher etwa ein Vielfaches von 45° gegenüber jedem anderen Raster ist, und
das ausgerichtete schwarze Farbraster mit den Primärfarbenrastern zur Erzeugung der farbigen Abbildung druckt.

16. Computer gesteuerte Vorrichtung zur Erzeugung von Halbtonrastern, welche eine farbige Abbildung wiedergeben, mit
Mitteln zum Abtasten einer zuvor aufgezeichneten Szene zur Erzeugung von Information, welche Farbe und Tonvariation in der Szene entspricht,
Mitteln zur Verarbeitung der Information zur Erzeugung von Halbtonrastern, welche den Primärfarben und der Schwarztonvariation in der Szene entsprechen, und
Mitteln zur Erzeugung der Halbtonraster in oder auf einem Ausgabemedium,
wobei die Mittel zur Verarbeitung Mittel zur Erzeugung von Cyan- und Magenta-Rastern, welche Druckbereiche mit einwärts gekrümmten Rändern haben, und Mittel zur Ausrichtung jedes Primärfarbenrasters in einem Winkel, welcher etwa ein Vielfaches von 45° gegenüber jedem anderen Primärfarbenraster ist, umfassen.

17. Vorrichtung nach Anspruch 16, wobei die Mittel zur Verarbeitung weiterhin Mittel zur Erzeugung von Tonvariation in den Primärfarbenhalbtonrastern durch Erzeugung von Druckbereichen, welche in Längsrichtung zwischen hallen und dunklen Tönen vartieren, umfassen.

18. Vorrichtung nach Anspruch 16, wobei die Mittel zur Verarbeitung weiterhin Mittel zur Erzeugung von Tonvariation in den Primärfarbenhalbtonrastern durch Erzeugung von Nicht-Druckbereichen, welche in Längsrichtung zwischen dunklen und hellen Tönen variieren, umfassen.

19. Computer gesteuerte Vorrichtung zur Erzeugung von Halbtonrastern, welche eine farbige Abbildung wiedergeben, mit
(a) Mitteln zum Empfangen von Information, welche Farbe und Tonvariation in der Abbildung entspricht,
(b) Mitteln zur Verarbeitung der Information zur Erzeugung von Halbtonrastern, welche Primärfarben in der Abbildung entsprechen, und
(c) Mitteln zur Erzeugung von Halbtonrastern, welche Primärfarben in einer für anschließendes Drucken der Abbildung geeigneten Form entsprechen,
wobei die Mittel zur Verarbeitung Mittel zur Erzeugung von Cyan- und Magenta-Rastern, welche Druckbereiche mit einwärts gekrümmten Rändern haben, und Mittel zur Ausrichtung jedes Primärfarbenrasters in einem Winkel, welcher etwa ein Vielfaches von 45° gegenüber jedem anderen Primärfarbenraster ist, umfassen.

20. Vorrichtung nach Anspruch 19, wobei die Mittel zur Verarbeitung Mittel zur Erzeugung von Tonvariation in den Primärfarbenhalbtonrastern durch Erzeugung von Druckbereichen, welche in Längsrichtung zwischen hellen und dunklen Tönen variieren, umfassen.

21. Vorrichtung nach Anspruch 20, wobei die Mittel zur Verarbeitung Mittel zur Verbindung der Druckbereiche in zwei verschiedenen Stufen, während der Ton dunkler bzw. heller wird, umfassen.

22. Vorrichtung nach Anspruch 19, wobei die Mittel zur Verarbeitung Mittel zur Erzeugung von Tonvariation in den Primärfarbenhalbtonrastern durch Erzeugung von Nicht-Druckbereichen, welche in Längsrichtung zwischen dunklen und hellen Tönen variieren, umfassen.

23. Vorrichtung nach Anspruch 22, wobei die Mittel zur Verarbeitung Mittel zur Verbindung der Nicht-Druckbereiche in zwei verschiedenen Stufen, während der Ton dunkler bzw. heller wird, umfassen.

24. Verfahren zur Herstellung einer Halbtonabbildung, wobei eine Tonvariation in Cyan- und Magenta-Rastern durch die Stufen erzeugt wird, in denen man
Druckbereiche erzeugt, welche einwärts gekrümmte Ränder haben, und
jedes Primärfarbenraster in einem Winkel anordnet, welcher ein Vielfaches von etwa 45° gegenüber jedem anderen Primärfarbenraster ist.

25. Halbtonabbildung, bei welcher Tonvariationen zumindest zum Teil durch gedruckte Bereiche erzeugt werden, welche einwärts gekrümmte Ränder haben und in welchen jedes Primärfarbenraster in einem Winkel ausgerichtet ist, welcher etwa ein Vielfaches von 45° gegenüber jedem anderen Primärfarbenraster ist.

26. Abbildung nach Anspruch 25, in welcher eine Tonvariation in Cyan- und Magenta-Rastern erzeugt wird, indem man Bereiche in hellen Tönen druckt, die als Punkte ausgebildet sind, welche zunehmend zu dunkleren Tönen verlängert sind.

27. Abbildung nach Anspruch 25, bei welcher Cyan- und Magenta-Raster etwa 90° zueinander ausgerichtet sind.

28. Abbildung nach Anspruch 25, bei welcher Gelb- und Schwarz-Raster etwa 90° zueinander ausgerichtet sind.

## Revendications

1. Procédé de préparation de trames de demi-teinte avant d'imprimer une image en couleurs comprenant les étapes :
(a) de réception de l'information représentant une variation de couleur et de ton de l'image ;
(b) de traitement de l'information pour créer des trames de demi-teinte représentant des couleurs primaires de l'image,
1) en créant des trames de cyan et de magenta comportant des zones d'impression à bords incurvés vers l'intérieur, et
2) en orientant chaque trame de couleur primaire à un angle qui est à peu près un multiple de 45° par rapport à une quelconque autre trame de couleur primaire ; et
(c) de production de trames de demi-teinte représentant des couleurs primaires en une forme appropriée pour impression ultérieure de l'image en couleurs.

2. Procédé selon la revendication 1, comprenant en outre l'étape :
de création des trames de cyan et de magenta comportant des zones d'impression de tons clairs formées en tant que points dont la longueur va en augmentant avec l'assombrissement des tons.

3. Procédé selon la revendication 2, comprenant en outre :
la liaison des points en deux étages distincts à mesure que le ton s'assombrit.

4. Procédé selon la revendication 1, comprenant en outre l'étape :
de création des trames de cyan et de magenta, comportant des zones sans impression de tons sombres formées en tant que points dont la longueur va en augmentant avec l'éclaircissement des tons.

5. Procédé selon la revendication 4, comprenant en outre :
la liaison des points en deux étages distincts à mesure que le ton s'éclaircit.

6. Procédé selon la revendication 1, comprenant en outre l'étape :
de création de trames de cyan et de magenta qui sont décalées relativement.

7. Procédé selon la revendication 1, comprenant en outre l'étape :
de création de trames de cyan et de magenta comportant des zones d'impression qui, dans des tons clairs, sont incurvées vers l'intérieur sur chaque bord.

8. Procédé selon la revendication 1, comprenant en outre l'étape :
de création de chaque trame de couleur primaire comportant des zones d'impression à bords incurvés vers l'intérieur.

9. Procédé selon la revendication 1, comprenant en outre l'étape :
de création d'une trame de noir comportant des zones d'impression à bords incurvés vers l'intérieur.

10. Procédé selon la revendication 9, comprenant en outre l'étape :
d'orientation de trames de jaune et de noir à un angle d'à peu près 90° l'une par rapport à l'autre.

11. Procédé selon la revendication 9, comprenant en outre l'étape :
d'orientation de la trame de noir à un angle qui est environ un multiple de 45° par rapport à une quelconque autre trame.

12. Procédé selon la revendication 11, comprenant en outre l'étape :
de création de la trame de noir avec une définition de trame qui est réduite d'un facteur d'à peu près 0,71 par rapport aux trames de cyan et de magenta.

13. Procédé selon la revendication 1, comprenant en outre l'étape :
d'orientation des trames de cyan et de magenta à un angle d'environ 90° l'une par rapport à l'autre.

14. Procédé d'impression de trames de demi-teinte pour former une image en couleurs, comprenant les étapes :
(a) de réception de l'information représentant des trames de demi-teinte de couleur primaire, dans lequel les trames de cyan et de magenta comportent des zones d'impression à bords incurvés vers l'intérieur ;
(b) d'orientation de chaque trame de couleur primaire à un angle qui est environ un multiple de 45° par rapport à une quelconque autre trame de couleur primaire ; et
(c) de superposition et d'impression des trames de couleur primaire orientées pour former une image en couleurs.

15. Procédé selon la revendication 14, comprenant en outre les étapes :
de réception de l'information représentant une trame de demi-teinte de noir,
d'orientation de la trame de demi-teinte de noir à un angle qui est environ un multiple de 45° par rapport à une quelconque autre trame, et
d'impression de la trame de couleur de noir avec les trames de couleur primaire pour former l'image en couleurs.

16. Appareil commandé par ordinateur destiné à préparer des trames de demi-teinte représentant une image en couleurs, comprenant :
un moyen destiné à balayer une scène enregistrée au préalable pour produire de l'information représentant une variation de couleur et de ton de la scène ;
un moyen destiné à traiter l'information pour créer des trames de demi-teinte représentant la variation de couleurs primaires et de tons de noir de la scène ; et
un moyen destiné à produire les trames de demi-teinte dans, ou sur, un support de sortie ;
dans lequel le moyen de traitement comprend un moyen destiné à créer des trames de cyan et de magenta comportant des zones d'impression à bords incurvés vers l'intérieur, et un moyen destiné à orienter chaque trame de couleur primaire à un angle qui est environ un multiple de 45° par rapport à une quelconque autre trame de couleur primaire.

17. Appareil selon la revendication 16, dans lequel le moyen de traitement comprend en outre un moyen destiné à produire une variation de ton des trames de demi-teinte de couleur primaire en créant des zones d'impression qui varient du point de vue de la longueur entre des tons clairs et sombres.

18. Appareil selon la revendication 16, dans lequel le moyen de traitement comprend en outre un moyen destiné à produire une variation de ton des trames de demi-teinte de couleur primaire en créant des zones sans impression qui varient du point de vue de la longueur entre des tons sombres et clairs.

19. Appareil commandé par ordinateur destiné à préparer des trames de demi-teinte représentant une image en couleurs, comprenant :
(a) un moyen destiné à recevoir de l'information représentant une variation de couleur et de ton de l'image ;
(b) un moyen destiné à traiter l'information pour créer des trames de demi-teinte représentant des couleurs primaires de l'image ; et
(c) un moyen destiné à produire des trames de demi-teinte représentant des couleurs primaires en une forme appropriée pour impression ultérieure de l'image ;
dans lequel le moyen de traitement comprend un moyen destiné à créer des trames de cyan et de magenta comportant des zones d'impression à bords incurvés vers l'intérieur, et un moyen destiné à orienter chaque trame de couleur primaire à un angle qui est environ un multiple de 45° par rapport à une quelconque autre trame de couleur primaire.

20. Appareil selon la revendication 19, dans lequel le moyen de traitement comprend un moyen destiné à produire une variation de ton dans les trames de demi-teinte de couleur primaire, en créant des zones d'impression qui varient du point de vue de la longueur entre des tons clairs et sombres.

21. Appareil selon la revendication 20, dans lequel le moyen de traitement comprend un moyen destiné à lier les zones d'impression en deux étages distincts à mesure, respectivement, que le ton s'assombrit ou s'éclaircit.

22. Appareil selon la revendication 19, dans lequel le moyen de traitement comprend un moyen destiné à produire une variation de ton dans les trames de demi-teinte de couleur primaire, en créant des zones sans impression qui varient du point de vue de la longueur entre des tons sombres et clairs.

23. Procédé selon la revendication 22, dans lequel le moyen de traitement comprend un moyen destiné à lier les zones sans impression en deux étages distincts à mesure, respectivement, que le ton s'assombrit ou s'éclaircit.

24. Procédé de préparation d'une image en demi-teinte dans lequel on produit une variation de ton dans des trames de cyan et de magenta par les étapes :
de création de zones d'impression qui comportent des bords incurvés vers l'intérieur ; et
de placement de chaque trame de couleur primaire à un angle qui est environ un multiple de 45° par rapport à une quelconque autre trame de couleur primaire.

25. Image de demi-teinte dans laquelle on produit des variations de ton au moins partiellement à l'aide de zones imprimées qui comportent des bords incurvés vers l'intérieur, et dans lesquelles chaque trame de couleur primaire est orientée à un angle qui est environ un multiple de 45° par rapport à une quelconque autre trame de couleur primaire.

26. Image selon la revendication 25, dans laquelle on produit une variation de ton dans des trames de cyan et de magenta en imprimant des zones de tons clairs formées en tant que points dont la longueur va en augmentant dans les tons plus sombres.

27. Image selon la revendication 25, dans laquelle des trames de cyan et de magenta sont orientées à un angle d'environ 90° l'une par rapport à l'autre.

28. Image selon la revendication 25, dans laquelle des trames de jaune et de noir sont orientées à un angle d'environ 90° l'une par rapport à l'autre.
